Europäisches Patentamt

**European Patent Office**

**Office européen des brevets**

(19)

(11) Numéro de publication: **0 173 616**
A1

# (12) DEMANDE DE BREVET EUROPEEN

(21) Numéro de dépôt: **85401588.0**

(22) Date de dépôt: **02.08.85**

(51) Int. Cl.⁴: **C 04 B 35/10,** C 04 B 35/46, H 01 B 3/12, H 01 L 23/14

(30) Priorité: **03.08.84 FR 8412332**

(43) Date de publication de la demande: **05.03.86** **Bulletin 86/10**

(84) Etats contractants désignés: **DE GB IT NL**

(71) Demandeur: **L.C.C.-C.I.C.E. - COMPAGNIE EUROPEENNE DE COMPOSANTS ELECTRONIQUES, 50, rue Jean-Pierre Timbaud B.P. 301, F-92402 Courbevole (FR)**

(72) Inventeur: **Filhol, Pierre, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 173, boulevard Haussmann, F-75379 Paris Cedex 08 (FR)**

(54) Substrat en céramique diélectrique et procédé d'obtention.

(57) L'invention concerne un substrat en céramique diélectrique.

Ce substrat est obtenu à partir des seuls oxydes d'aluminium, de magnésium et de titane, les oxydes de magnésium et de titane intervenant dans des proportions molaires sensiblement équivalentes.

Un tel substrat est utilisable en électronique dans les technologies de type couches minces ou couches épaisses, dans les boîtiers de protection de puces, les substrats multicouches, etc.

SUBSTRAT EN CERAMIQUE DIELECTRIQUE ET PROCEDE D'OBTENTION

L'invention concerne des substrats en céramiques diélectriques et leur procédé de fabrication. De tels substrats sont utilisés en électronique et interviennent dans de nombreux produits tels que les substrats pour servir de support de circuiterie dans les technologies de types "couches minces" ou "couches épaisses", boîtiers de protection de puces ou d'interconnexion entre puces, substrats multicouches, etc...

L'alumine est le matériau le plus généralement employé pour la fabrication de ces céramiques.

Il importe, pour des applications en hyperfréquences, que la tangente de l'angle des pertes diélectriques tg δ du matériau soit faible, typiquement inférieures à $5.10^{-4}$ à 10 GHz. Une alumine 99,5 %, réactive, peut être frittée à des températures comprises entre 1500° C et 1600° C et présenter des tangentes d'angle de pertes inférieures à $2.10^{-4}$ jusqu'à 10 GHz. Des alumines de pureté moindre, 96 % ou 89 %, contenant essentiellement les éléments Si, Mg, Ca, Na, K, peuvent être frittées à des températures aussi basses que 1400° C mais présentent des tangentes d'angle de pertes supérieures à $10^{-3}$ à 10 GHz.

Il importe aussi pour un matériau utilisé comme substrat en microélectronique, que le grain de surface soit le plus fin possible, typiquement de l'ordre du micron. Ainsi, la rugosité superficielle de la céramique doit être la plus faible possible. On a intérêt d'autre part, à effectuer le frittage des matériaux à une température la plus basse possible.

L'invention permet de concilier ces exigences. En effet, l'invention fournit un substrat en céramique pouvant être fritté à des températures inférieures à 1400° C. La tangente d'angle de pertes diélectriques tg δ mesurée à 10 GHz de la céramique est inférieure à $5.10^{-4}$ et la céramique sous forme de substrat possède une rugosité superficielle faible.

L'invention concerne un substrat en céramique diélectrique, caractérisé en ce qu'il est obtenu à partir des seuls oxydes de magnésium, de titane et d'aluminium, les oxydes de magnésium et de titane intervenant dans des proportions molaires sensiblement équivalentes.

L'invention a également pour objet un procédé de réalisation d'un substrat, caractérisé en ce qu'il comporte les phases suivantes :

a) obtention d'un mélange de poudre d'oxyde de magnésium et de poudre d'oxyde de titane dans des proportions sensiblement équivalentes ;

b) calcination du mélange précédent ;

c) préparation d'une barbotine à l'aide du mélange calciné précédent, d'une poudre d'alumine, d'un liant et d'un solvant ;

d) mise en forme et séchage de la barbotine obtenue pour obtention d'un substrat ;

e) frittage du substrat cru après élimination du liant de telle façon que la grosseur des grains de la surface du substrat obtenu soit en moyenne d'un micron.

Les différents objets et caractéristiques de l'invention seront mieux compris à la lecture de la description qui va suivre. Cette description s'appuie sur des exemples numériques de façon à simplifier et illustrer les explications. Il est bien évident que ces exemples numériques ne sont pas limitatifs.

Pour obtenir le substrat de l'invention, on procède selon les différentes phases successives suivantes.

Lors d'une première phase, on effectue un mélange de poudre d'oxyde de magnésium MgO très fine et de poudre d'oxyde de titane $TiO_2$ très fine. La proportion molaire de chaque oxyde dans le mélange est comprise entre 0,9 et 1,1 pour chaque oxyde. De préférence, on prendra une même proportion de chaque oxyde.

Lors d'une deuxième phase, les deux poudres d'oxydes soigneusement mélangées sont calcinées à une température comprise entre 1000° C et 1300° C. La calcination donne lieu à une réaction chimique des deux oxydes et produit une poudre fine d'oxyde de magnésium et de titane.

Lors d'une troisième phase, le mélange ainsi calciné est utilisé pour préparer une barbotine par addition d'une poudre d'alumine fine, d'un liant et d'un solvant. Le mélange calciné ainsi que l'alumine seront constitués de poudre dont la dimension des grains est inférieure au micron. On utilise comme liant de l'alcool polyvinylique, du polyvinyl butyral ou du polyméthacrylate de méthyle. Le solvant utilisé sera un solvant connu dans la technique et approprié au liant.

A cette barbotine peuvent être également ajoutés, selon le mode de mise en forme, des défloculants ou des plastifiants.

Lors d'une quatrième phase, la barbotine obtenue est coulée puis séchée selon les techniques connues.

Enfin, lors d'une cinquième phase, on procède au frittage du substrat ainsi obtenu après élimination du liant incorporé.

Il est à noter que dans la deuxième phase précédemment décrite, la calcination de la poudre du mélange d'oxyde de magnésium MgO et d'oxyde de titane $TiO_2$ est contrôlée de façon que la taille moyenne des grains soit de 0,5 $\mu$m. La granulométrie de la poudre calcinée dépend de la taille des grains des poudres de départ, typiquement inférieure à 0,5 $\mu$m et de la température de calcination typiquement comprise entre 1000° C et 1280° C.

Dans la troisième phase, prévoyant un mélange, à la poudre calcinée de MgO et de $TiO_2$ d'une poudre d'alumine, on utilisera une poudre d'alumine $Al_2O_3$ dont la taille moyenne des grains est aussi de 0,5 $\mu$m.

On obtient ainsi une poudre de granulométrie moyenne de 0,5 micron, ce qui permet après mise en forme par coulage et après frittage, d'avoir une taille de grains superficiels de l'ordre du micron.

Le matériau obtenu est donc constitué de magnésium, de titane, d'aluminium et d'oxygène.

Différentes mesures ont été effectuées sur des matériaux réalisés selon le procédé de l'invention. C'est ainsi qu'on a mesuré, la densité, la rugosité, la constante diélectrique et la tangente d'angle des pertes diélectriques à 10 GHz.

Dans les exemples qui ont été choisis et qui sont décrits ci-après, les matériaux ont la forme de substrats de 5 sur 5 cm de côté et de 0,5 à 1 mm d'épaisseur. Ils sont constitués d'une quantité équimolaire de MgO et de $TiO_2$, et de 1 % à 98 % en poids d'alumine par rapport au poids total de MgO et de $TiO_2$. Leur densité est comprise entre 3,48 et 3,87 g/cm$^3$. Leur constante diélectrique est comprise entre 9,1 et 17,1 ; leurs tangentes d'angle de pertes diélectriques sont inférieures à $5.10^{-4}$. De plus, ces substrats ont une rugosité superficielle inférieure à 0,15 $\mu$m ($R_A$) et peuvent être utilisés sans usinage mécanique de rodage ou de polissage :

cette finesse de la surface est liée à la petitesse des grains superficiels (1 $\mu$m) qui sont obtenus grâce au procédé de fabrication.

Dans les tableaux 1 et 2 placés en fin de la présente description, on a résumé des résultats de mesures effectuées pour différentes proportions d'alumine et de mélange d'oxydes de magnésium et de titane.

Pour les différentes compositions, on a réalisé des matériaux en prévoyant, lors de la phase de frittage du procédé décrit précédemment, des températures de frittage différentes, telles que 1220° C, 1260° C, 1300° C, etc ...

Pour chacun des substrats obtenus, on a mesuré la densité d en gramme par $cm^3 (g/cm^3)$.

- la constante diélectrique $\varepsilon'$ à la fréquence de 10 GHz ;

- la tangente des pertes diélectriques tg$\delta$ à la fréquence de 10 GHz.

Les matériaux ont été optimisés pour avoir tg$\delta$ inférieure à $5.10^{-4}$.

On s'aperçoit lors des mesures, et comme on peut le lire sur le tableau de résultats de mesure, qu'en ajoutant un mélange d'oxydes MgO-TiO$_2$ à l'alumine Al$_2$O$_3$, il est possible de diminuer la température de frittage, ce qui est un avantage de l'invention, et celà sans perdre sur les caractéristiques diélectriques. De même en ajoutant de l'alumine au mélange MgO-TiO$_2$, on diminue la constante diélectrique sans beaucoup augmenter la température de frittage. En effet, le premier cas du tableau n° 1 prévoyant un mélange de 100 % d'oxyde de magnésium et d'oxyde de titane ainsi que le dernier cas du tableau n° 2 comportant 100 % d'alumine, sont des cas connus dans la technique. Le premier cas révèle des constantes diélectriques élevées, tandis que le deuxième cas nécessite des températures de frittage élevées.

Par ailleurs, selon les mesures faites, il apparaît que des matériaux particulièrement intéressants sont obtenus quand on choisit la composition du mélange de poudres de telle façon que la proportion en poids d'oxyde d'aluminium par rapport au poids total des oxydes de magnésium et de titane soit compris entre 1 % et 35 % ou entre 80 % et 98 %. De cette façon, on obtiendra des caractéristiques électriques meilleures pour des températures de frittage inférieures à 1380 degrés centésimaux : tangente d'angle de pertes diélectriques inférieures à $2.10^{-4}$ à 10 GHz.

Il apparaît donc que le matériau de l'invention à base de magnésium, de titane, et d'aluminium présente un intérêt dans la fabrication des substrats en ce qui concerne la valeur des pertes diélectriques et les températures de frittage plus basses que celle de l'alumine, une constante diélectrique plus faible que celle du titanate de magnésium.

En effet, les matériaux de l'invention ont une constante diélectrique comprise entre 9,1 et 17,1, des pertes diélectriques inférieures à $5.10^{-4}$ à 10 GHz, lorsque produits sous forme de substrats, ils ont une rugosité superficielle $R_A$ inférieure à 0,15 $\mu$m.

Il est entendu que toute composition intermédiaire aux compositions des exemples, conviennent pour réaliser des substrats diélectriques, à rugosité superficielle inférieure à 0,15 $\mu$m. Ces substrats présentent en outre l'intérêt d'être utilisables sans usinage mécanique supplémentaire.

Des métaux tels que chrome, cuivre, or, etc ... peuvent être déposés en couche mince, de l'ordre de quelques centaines d'Angströms d'épaisseur sans discontinuité, par évaporation, pulvérisation ou autre technique. Ces dépôts peuvent être traités par des techniques de photogravures : des pistes de conducteurs peuvent être ainsi formées sur ces substrats avec une bonne définition, typiquement quelques dizaines de microns de large et quelques microns d'épaisseur, grâce à la finesse du grain superficiel. Les caractéristiques aux hyperfréquences des circuits électriques réalisés sur de tels substrats sont ainsi très satisfaisants.

| Composition en poids | Température de frittage °C | 1220 | 1260 | 1300 | 1340 | 1380 | 1420 | 1460 | 1500 |
|---|---|---|---|---|---|---|---|---|---|
| $\geqslant$ 99 % MgO-TiO$_2$ | d | - | 3,75 | 3,76 | 3,78 | - | | | |
| | ε' | 16,8 | 17,1 | 17,1 | 17 | - | | | |
| | tgδ .10$^4$ | 36 | 2,5 | 1,5 | 4 | - | | | |
| 90 % MgO-TiO$_2$ + 10 % Al$_2$O$_3$ | d | 3,64 | 3,56 | 3,69 | 3,73 | 3,70 | 3,68 | | |
| | ε' | 13,4 | 15,3 | 15,9 | 16,6 | 16,1 | 16 | | |
| | tgδ .10$^4$ | 5 | 1 | 2,8 | 1,7 | 1 | 1,5 | | |
| 70 % MgO-TiO$_2$ + 30 % Al$_2$O$_3$ | d | | 3,48 | 3,52 | 3,59 | 3,58 | 3,58 | | |
| | ε' | | 11,3 | 14,1 | 14,2 | 14,4 | 14,4 | | |
| | tgδ .10$^4$ | | 5,4 | 2,7 | 3 | 1,4 | 3,5 | | |
| 50 % MgO-TiO$_2$ +50 % Al$_2$O$_3$ | d | | | | 3,61 | 3,59 | 3,59 | 3,59 | |
| | ε' | | | | 12,9 | 13 | 13 | - | |
| | Tgδ . 10$^4$ | | | | - | 10 | 5 | - | |

TABLEAU N° 1

6

0173616

| Composition en poids | Température de frittage °C | 1220 | 1260 | 1300 | 1340 | 1380 | 1420 | 1460 | 1500 |
|---|---|---|---|---|---|---|---|---|---|
| 30 % MgO-TiO$_2$ + 70 % Al$_2$O$_3$ | d | | | | 3,59 | 3,68 | 3,69 | | |
| | $\varepsilon'$ | | | | 10,3 | 11,1 | 11,6 | | |
| | tg$\delta$ . $10^4$ | | | | – | 7 | 5 | | |
| 10 % MgO-TiO$_2$ + 90 % Al$_2$O$_3$ | d | | | – | 3,78 | 3,83 | 3,85 | 3,84 | 3,86 |
| | $\varepsilon'$ | | | – | 9,8 | 10,2 | 10,2 | 10,4 | 10,4 |
| | tg$\delta$ .$10^4$ | | | – | 1,2 | 1,5 | 1 | 3 | 2 |
| >99 % Al$_2$O$_3$ | d | | | | | | | 3,81 | 3,87 |
| | $\varepsilon'$ | | | | | | | 9,1 | 9,5 |
| | tg $\delta$ .$10^4$ | | | | | | | 2,8 | 1,4 |

TABLEAU Nº 2

7

## REVENDICATIONS

1. Substrat en céramique diélectrique, caractérisé en ce qu'il est obtenu à partir des seuls oxydes d'aluminium, de magnésium et de titane, les oxydes de magnésium et de titane intervenant dans des proportions molaires sensiblement équivalentes.

2. Substrat en céramique selon la revendication 1, caractérisé en ce que la proportion en poids d'oxyde d'aluminium par rapport au poids total des oxydes de magnésium et de titane est comprise entre 1 % et 98 %.

3. Substrat en céramique selon l'une des revendications 1 ou 2, caractérisé en ce que la proportion en poids d'oxyde d'aluminium par rapport au poids total des oxydes de magnésium et de titane est comprise entre 1 % et 35 %.

4. Substrat en céramique selon l'une des revendications 1 ou 2, caractérisé en ce que la proportion en poids d'oxyde d'aluminium par rapport au poids total des oxydes de magnésium et de titane est comprise entre 80 et 98 %.

5. Procédé de réalisation d'un substrat selon l'une des revendications précédentes, caractérisé en ce qu'il comporte les phases suivantes :

a) obtention d'un mélange de poudre d'oxyde de magnésium et de poudre d'oxyde de titane dans des proportions sensiblement équivalentes ;

b) calcination du mélange précédent ;

c) préparation d'une barbotine à l'aide du mélange calciné précédent, d'une poudre d'alumine, d'un liant et d'un solvant ;

d) mise en forme et séchage de la barbotine obtenue pour obtention d'un substrat ;

e) frittage du substrat obtenu après élimination du liant de telle façon que la grosseur des grains de la surface du substrat obtenu soit en moyenne d'un micron.

6. Procédé de réalisation d'un substrat selon la revendication 5, caractérisé en ce que la température de calcination est comprise entre 1000 et 1300° centésimaux.

7. Procédé de réalisation d'un substrat selon la revendication 5, caractérisé en ce que, la proportion d'alumine peut être choisie entre 1 % et 98 %.

8. Procédé de réalisation d'un substrat selon la revendication 5, caractérisé en ce que la poudre d'alumine et la poudre du mélange calciné ont une granulométrie moyenne de l'ordre de 0,5 micron.

9. Procédé de réalisation d'un substrat selon la revendication 5, caractérisé en ce que la température de frittage est inférieure à 1380° centésimaux.

10. Procédé de réalisation d'un substrat selon l'une des revendications 2 à 5, caractérisé en ce que la proportion en poids d'oxyde d'alumine est dans un rapport déterminé par rapport au poids total des oxydes de magnésium et de titane.

## RAPPORT DE RECHERCHE EUROPEENNE

Office européen
des brevets

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| P,X | EP-A-0 145 599 (EUROFARAD EFD)<br><br>* Revendications 1,3; page 7, lignes 18-32; page 8, lignes 8-33; page 17, lignes 28-35; page 9, lignes 1-16 * | 1,2,4, 5,7-10 | C 04 B 35/10<br>C 04 B 35/46<br>H 01 B 3/12<br>H 01 L 23/14 |
| Y | | 3,6 | |
| X | --- <br>CHEMICAL ABSTRACTS, vol. 93, no. 14, 6 octobre 1980, page 617, no. 141880u, Columbus, Ohio, US; & PL - B - 104 006 (KOMBINAT PRODUKCYJNO-NAUKOWY PODZESPOLOW ELEKTRONICZNYCH "UNITRA-ELPOD") 22-12-1979<br>* Résumé * | 1,2,4, 7,9,10 | |
| Y | --- | 3,5,6, 8 | DOMAINES TECHNIQUES RECHERCHES (Int. Cl. 4)<br><br>C 04 B<br>H 01 B<br>H 01 L |
| Y | --- <br>FR-A-1 565 857 (LITTON INDUSTRIES)<br>* Résumé A, points 1-4 * | 3 | |
| Y | --- <br>US-A-2 305 327 (H. THURNAUER)<br>* Revendication 1 * | 5,6 | |
| Y | --- <br>FR-A-1 564 260 (WESTERN ELECTRIC CO.)<br>* Résumé * | 5,8 | |
| | ---     -/- | | |

Le présent rapport de recherche a été établi pour toutes les revendications

| Lieu de la recherche | Date d'achèvement de la recherche | Examinateur |
|---|---|---|
| LA HAYE | | SCHURMANS H.D.R. |

0173616

# RAPPORT DE RECHERCHE EUROPEENNE

Numero de la demande

EP 85 40 1588

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| A | CHEMICAL ABSTRACTS, vol. 90, no. 16, avril 1979, page 688, no. 131758j, Columbus, Ohio, US; & JP - A - 78 149 696 (SONY CORP.) 27-12,1978 --- | 1-10 | |
| A | CHEMICAL ABSTRACTS, vol. 95, no. 4, août 1981, page 690, no. 71943g, Columbus, Ohio, US; & JP - A - 81 37 274 (TAIYO YUDEN CO., LTD.) 10-04-1981 ----- | | |

DOMAINES TECHNIQUES RECHERCHES (Int. Cl.4)

Le présent rapport de recherche a été établi pour toutes les revendications

| Lieu de la recherche | Date d'achèvement de la recherche | |
|---|---|---|
| LA HAYE | 26-11-85 | SCHURMANN H. Dr. R. Examinateur |